# EUROPEAN PATENT SPECIFICATION

(11) **EP 0 320 013 B1**
(45) Date of publication and mention of the grant of the patent: **26.01.1994**
(21) Application number: 88120654.4
(22) Date of filing: 09.12.1988
(51) Int. Cl.: H01G 1/035

(54) **Chip type capacitor and manufacturing thereof**
Chipkondensator und Verfahren zur Herstellung
Condensateur du type pastille et procédé de fabrication

(30) Priority: 09.12.1987 JP 311410/87; 24.12.1987 JP 328032/87; 28.12.1987 JP 332923/87; 26.02.1988 JP 43681/88; 15.04.1988 JP 92885/88; 30.04.1988 JP 108414/88; 30.04.1988 JP 108415/88; 15.06.1988 JP 147880/88; 29.06.1988 JP 161430/88; 09.12.1987 JP 311409/87; 09.12.1987 JP 311412/87
(43) Date of publication of application: 14.06.1989
(60) Divisional application: 92116062.8
(73) Proprietor: NIPPON CHEMI-CON CORPORATION, Tokyo 198 (JP)
(72) Inventor: Hagiwara, Ikuo, Higashi-Ome Ome-shi Tokyo 198 (JP); Ando, Susumu, Higashi-Ome Ome-shi Tokyo 198 (JP); Fujiwara, Masayuki, Higashi-Ome Ome-shi Tokyo 198 (JP); Endo, Keiichi, Higashi-Ome Ome-shi Tokyo 198 (JP); Kawahara, Hideki, Higashi-Ome Ome-shi Tokyo 198 (JP); Hirano, Makoto, Higashi-Ome Ome-shi Tokyo 198 (JP)
(74) Representative: Patentanwälte Dipl.-Ing. R. Splanemann Dr. B. Reitzner Dipl.-Ing. K. Baronetzky

(56) References cited:
- EP-A- 0 169 261
- EP-A- 0 192 818
- EP-A- 0 228 122
- JP-A-60 245 116
- US-A- 4 561 041

## Description

This invention relates to an improvement of a chip type capacitor suitable for mounting on the surface of a printed circuit board.

Hitherto, the capacitor chipping has been realized such that a capacitor element is first accommodated in a sheathing case of the synthetic resin for subjecting to a resin mold processing and then the terminals used for an exterior connection terminal derived from an end of the resin were bent alongside the end of the resin to match with the wiring pattern of the printed circuit board.

Further, there is proposed to accommodate the conventional capacitor in a sheathing frame and to arrange the terminals in the same plane as the end of the sheathing frame as disclosed in the Japanese Utility Model Publication 59-3557. Furthermore, another proposal is to arrange a capacitor on a closed-end cylindrical sheathing frame for derivation of the terminals from a through-hole on the underside of the sheathing frame and to bend the terminals in a concave section provided on the external surface of the sheathing frame as disclosed in the Japanese laid-open patent publication 60-245116 and the Japanese laid-open patent publication 60-24511.

These conventional chip type capacitors are capable of a surface mounting without changing the ordinary structure of the capacitor.

However, in the conventional chip type capacitor with the mold processing, capacitor elements are likely to have a heat deterioration due to a thermal stress during the mold processing. Moreover, particularly for an electrolytic capacitor, it is necessary to mold an electrolyte in a liquid state together with capacitor elements and since the mold processing requires sophisticated sealing properties, the manufacturing process is likely complex.

Moreover, in the chip type capacitors in which an ordinary capacitor is accommodated in the sheathing frame, there have been neither means available for suspending a body of the capacitor in the accommodating space provided in the sheathing frame nor means to determine the position of the body of the capacitor in the sheathing frame, for which reason it will not only cause the position used as a reference for the bending process of the lead wire to be unreliable but generate an unnecessary stress to be applied on the lead wire, which may affect capacitor elements badly in the course of processing.

Furthermore, as the case may be, the body of the capacitor easily falls off from the sheathing frame with difficulty in manufacturing a chip type capacitor.

Furthermore, when a capacitor is accommodated in a closed-end cylindrical sheathing frame, fixing and positioning of the body of the capacitor may be available, notwithstanding lead wires must be inserted through the through-hole provided on the underside of the sheathing frame with an inconvenient manufacturing process. In other words, according to this process, normally two lead wires derived from the capacitor must be inserted through the through-hole provided on the underside of the sheathing frame while accommodating the capacitor in the sheathing frame. Accordingly, an adjustment must be made to the directions of the body of the capacitor and the sheathing frame as well as to the position and direction of the lead wires derived from the body of the capacitor, for which reason a high processing accuracy is required resulting in an disadvantage of the sophisticated manufacturing process

The chip type capacitor according to Japanese laid-open patent publication 60-24 51 16 has a block-shaped sheathing frame with two holes for receiving the lead wires of the capacitor. When bending the lead wires as desired with this capacitor, the wires usually made from metal do have elastic properties to some extend, thus avoiding enhanced accuracy. Also, the flexibility in arranging this capacitor is poor.

Therefore, it is an object of the present invention to provide a chip type capacitor assembly which may be produced easily, which is suitable for mounting on the surface of a printed ciurcuit board, without being affected by the processing accuracy during the manufacturing process and which has yet an enhanced accuracy and flexibility when arranging the capacitor assembly on the printed circuit board.

Such a capacitor may be made according to the features given in claim 1. Advantageous developments may be taken from the subclaims.

A wall section is arranged at the front end of the aperture in the sheathing frame which may cover a part thereof and is intended to lead the wires of the capacitor. These wires are bent alongside, preferably in notched slot sections in the wall section, to expose the lead wires outside of the sheathing frame.

Additionally to the protuberance arranged on the wall section, a protuberance of a height substantially identical to the height of the wall section protuberance may be arranged on the rear end of the underside of the sheathing frame.

Notched slot sections may be provided on the underside of the sheathing frame or on the side adjacent thereto to accomodate lead wires which may be led to the end of the sheathing frame which is opposed to the end of the wall section. Also, a resin layer may be arranged for one side of aperture of the sheathing frame, to cover a lead-out section of the lead wires.

Furthermore, by selecting the height of the protuberance or protuberances in a suitable way, the chip type capacitor may be utilized even if connection lines of a printed circuit board will run under the chip type capacitor. It is advantageous that the chip type capacitor according to the invention requires no substantial processing accuracy. The insertion of the capacitor body into the accommodating space is possible easily while the wall section provides a shoulder indicating that the capacitor is inserted to a sufficient extent.

Thus, the position of the capacitor in the accomodating space is conveniently determined. Inspite of the tolerances in manufacturing, the body of the capacitor does not fall off during the manufacturing process or from the completed chip type capacitor.

With the invention, it is possible to bend the lead wires conveniently to the intended distance which is compatible with the pattern of the printed circuit board, then after having inserted the capacitor into the sheathing frame, merely bending the wire along the wall section towards the underside of the sheathing frame.

A preferred embodiment of the chip type capacitor according to the invention is described in detail with reference to the accompaning drawings in which:
- Fig. 1: is a perspective view showing a chip type capacitor;
- Fig. 2: is a front elevation showing one embodiment of the sheathing frame of the chip type capacitor according to Fig. 1;
- Fig. 3: is a front elevation showing another embodiment of the sheathing frame of the chip type capacitor shown in Fig. 1;
- Fig. 4: is a perspective view of an example which is amended over the chip type capacitor shown in Fig. 1;
- Fig. 5: is a perspective view of an embodiment of the chip type capacitor according to the invention; and
- Fig. 6: is a perspective view of the example showing an amended shape of the capacitor shown in Fig. 5.

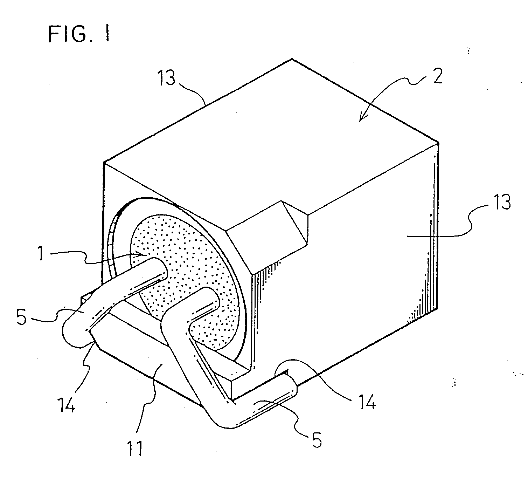

The embodiment shown in Fig. 1 comprises a capacitor 1 and a sheathing frame 2. The body of the capacitor 1 is comprised of the configuration wherein capacitor elements formed by winding an electrode foil or an electrolytic paper (not shown in the drawings) are accommodated in a closed-end cylindrical sheathing case 3 of aluminum or the like, and an end of an aperture of the sheathing case 3 is sealed with a sealing member. Lead wires 5,5 derived from capacitor elements are led out to the outside through the ceiling compound or ceiling member. The sheathing frame 2 has a cylindrical accommodating space compatible with the external diameter of the sheathing case 3 and is composed of an excellent heat resistant material. The sheathing frame 2 is preferably molded from excellent heat resistant synthetic resins such as epoxy, phenol, polyimide and the like, ceramics materials or excellent heat resistant elastic rubber materials.

In this embodiment, the accommodating space 5 of the sheathing frame 2 employs the cylindrical capacitor 1 such that the inner dimensions of the sheathing frame are substantially identical to the external dimension of the capacitor 1. However, when for instance a capacitor of non-cylindrical external shape is used, the inner dimensions of the sheathing frame ought to be made compatible with such a configuration.

As may be taken from Fig. 1, according to the embodiment shown therein, notched groove sections 14,14 are provided in the boundary between either sides 13,13 of the sheathing frame 2 and the underside 8. In this embodiment, groove sections 14,14 are slanted extending from both sides 13,13 of the sheathing frame 2 to the underside 8. Nevertheless, these groove sections 14,14 should only be suitable for accommodating the lead wires 5,5 and their shapes may optionally be selected.

As may be taken from Fig. 1, the sheathing frame 2 comprises a wall portion 11 which covers a part of the front aperture of the sheathing frame 2.

According to the embodiment, the lead wires 5,5 derived from the front end of the capacitor 1 are bent alongside the end of the aperture 10 of the sheathing frame 2 and then accommodated in the groove sections 14,14 provided in either sides 13,13 of the sheathing frame 2 to face the printed circuit board. For this reason, the lead wires 5,5 of the capacitor 1 are always provided by constantly distancing or keeping the distance between the groove sections 14,14 arranged on the sheathing frame 2 as shown in Fig. 1 free of an adjustment of the pitch between each of the lead wires 5,5.

Further, in the chip type capacitor according to the embodiment, the lead wires 5,5 of the capacitor are exposed from either sides 13,13 of the sheathing frame 2 so that when they are mounted on the printed circuit board 7 by soldering the bonded portion of the lead wires 5,5 with a soldering layer may be visually viewed from the outside with an improved reliability in the mounting condition.

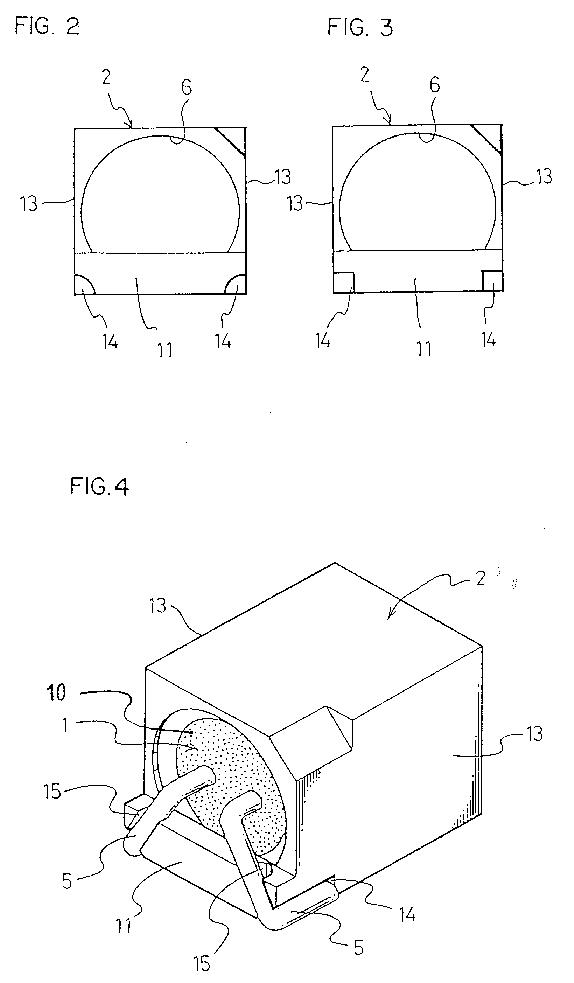

The groove sections 14,14 provided from either sides 13,13 of the sheathing frame 2 to the underside 8 may be of any shape suitable for accommodating the lead wires 5,5 of the capacitor 1, for example, they may be of arcs as shown in Fig. 2 or may be of retangular shapes as shown in Fig. 3.

Fig. 4 is a modification of the embodiment as shown in Fig. 1. According to this embodiment, groove sections 15,15 are provided in the surface of the wall section 11 which covers an aperture 10 of the sheathing frame 2 alongside the lead wires 5,5 of the capacitor 1 which are bent for contact. These groove sections 15,15 are formed into a shape suited for accommodating the lead wires 5,5 of the capacitor 1, such as a half-round shape. According to the embodiment, the lead wires 5,5 of the capacitor 1 are bent alongside from the front end of the aperture 10 of the sheathing frame 2 to the underside 8 but accommodated in the groove sections 15,15 at the wall section 11 so that they do not come out of the end the aperture 10 of the sheathing frame 2 from which the lead wires 5,5 are led out as in the aforementioned embodiment.

As it not might not come out clearly from Fig. 1 and 4, these embodiments are intended to show a protuberance which has a height which is larger then the thickness of the wires 5,5. With this protuberance, it is possible to greatly enhance the flexibility when arranging the chip type capacitor assembly on a printed circuit board, independently of connecting lines which might run under the chip type capacitor assembly.

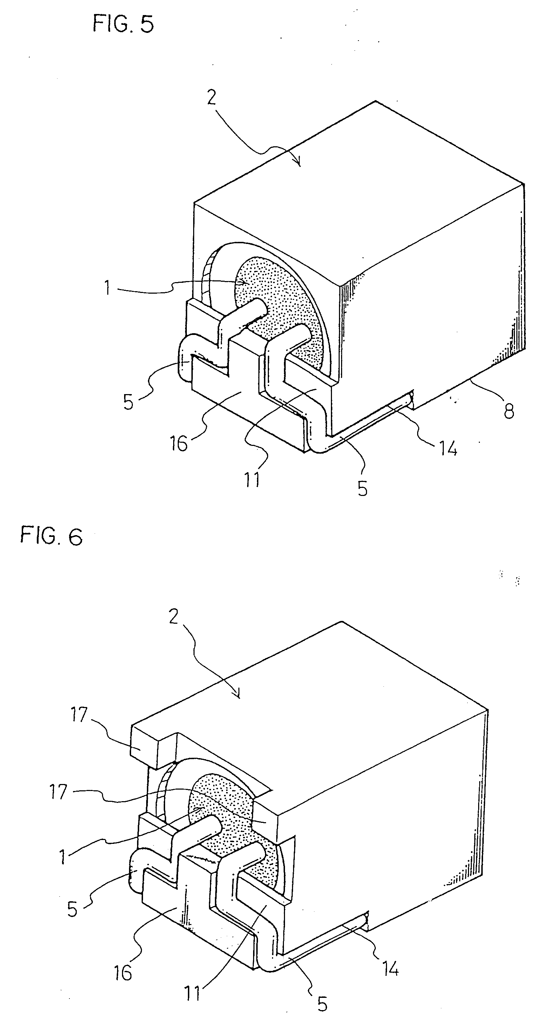

Fig. 5 and 6 show other embodiments of the chip type capacitor according to the invention. As in the previously mentioned embodiments, the wall section 11 is provided at the aperture 10 of the sheathing frame 2 to cover a part thereof, and a protuberance 16 is arranged in the vicinity of almost at the center portion of the wall section 11. The height of the protuberance 16 is substantially higher than the external diameter of the lead wires 5,5. In this case, the lead wires 5,5 are so bent alongside the surface of the wall section 11 to detour the protuberance 16 and are further bent alongside the underside 8 of the sheathing frame 2 for accommodating into the groove sections 14,14 provided on the underside 8. As a result, the protuberance 16 and the lead wires 5,5 are arranged in substantially the same plane at the end of the aperture 10 of the sheathing frame 2.

The protuberance 16 is provided in the vicinity of the center portion of the wall section 11 so that a plurality of the lead wires 5,5 led out from the capacitor 1 are separated from one another through the protuberance 16 to prevent a short-circuit accident to be caused by a contact of the lead wires 5,5 with each other.

However, when ordinary chip type electronic parts are actually mounted on a printed circuit board, the electronic parts at its four sides must be held down at the front and the rear, the left and the right by means of a jig to carry out a positioning process for an adjustment of the wiring positions. According to the chip type capacitor assembly of this embodiment, even electronic parts are held down by the jig during the positioning process, the protuberance 16 comes close to the jig but never is in contact with the jig, ensuring to perform a precise positioning with reduction of the mechanical stress to the capacitor elements due to the jig.

When the embodiment as illustrated in Fig. 5, like the chip type capacitor as shown in Fig. 10, the protuberance 17 is provided in the aperture 10 of the sheathing frame 2 in a height identical to the height of protuberance 16 provided in the wall section 11. In this case, the protuberance 16 of the wall section 11 is arranged in the same plane as the protuberance 17 at the aperture 10 of the sheathing frame 2. Accordingly, like the before mentioned embodiment, the stress to be caused by the jig to the lead wires 5,5 may be reduced, enabling to wire the lead wires 5,5 while contacting the aperture 10 of the sheathing frame 2 with the printed circuit board.

## Claims

1. A chip type capacitor assembly, comprising a capacitor (1) having lead wires (5) derived from terminals thereof and a sheathing frame (2) having an underside (8) and defining an accommodating space (6) complementary with the external shape of said capacitor (1) wherein the lead wires (5) of the capacitor (1) accommodated in the sheathing frame (2) are bent alongside of the sheathing frame (2) to the underside (8) of the sheathing frame (2), characterized by a protuberance of a height substantially identical to the external diameter of the lead wires (5) being provided on the underside (8) of the sheathing frame (2), that a single aperture for leading out the lead wires (5) is provided at a front end of the sheathing frame and that a protuberance (11, 16) of a thickness greater than the external diameter of the lead wires (5) of the capacitor (1) is arranged on a wall section (11) arranged at the front end of the aperture for covering a part thereof.

2. A chip type capacitor assembly according to claim 1, wherein a resin layer (19) is arranged to cover at least one lead-out section of the lead wires (5) from the capacitor sealing compound for one side of the aperture of the sheathing frame (2) from which lead wire (5) of the capacitor (1) accommodated in the sheathing frame (2) are led out.

3. A chip type capacitor assembly according to claim 1, wherein the wall section (11) is arranged at one end of the aperture on one side of the sheathing frame (2) to cover a part thereof and lead wires (5) of the capacitor (1) accommodated in the sheathing frame (2) are bent alongside from an aperture on one side of the sheathing frame (2) to the wall section (11) and the underside (8).

4. A chip type capacitor assembly according to claim 3, wherein slot sections (14, 15) are arranged to contain lead wires on the wall section (11) arranged at an end of the aperture on one side of the sheathing frame (2) to cover part thereof over which lead wires (2) of the capacitor are bent.

5. A chip type capacitor assembly according to claim 3, wherein at least one of said lead wires (2) runs alongside the underside (8) of the sheathing frame (2).

## Patentansprüche

1. Kondensatoranordnung der Chip-Art, mit einem Kondensator (1) mit Anschlußdrähten (5), die von Anschlüssen desselben abgeleitet sind, sowie einen Hüllrahmen (2) mit einer Unterseite (8), der einem Aufnahmeraum (6) komplimentär zu der äußeren Form des Kondensators (1) festlegt, wobei die Anschlußdrähte (5) des Kondensators (1), der in dem Hüllrahmen (2) aufgenommen ist, entlang dem Hüllrahmen (2) zu der Unterseite (8) des Hüllrahmens (2) gebogen sind, gekennzeichnet durch einen Vorsprung einer Höhe, die im wesentlichen gleich dem äußeren Durchmesser der Anschlußdrähte (5) ist, die auf der Unterseite (8) des Hüllrahmens (2) vorgesehen sind, sowie dadurch gekennzeichnet, daß eine einzige Öffnung für das Herausführen der Anschlußdrähte (5) an dem vorderen Ende des Hüllrahmens vorgesehen ist und daß ein Vorsprung (11, 16) einer Stärke, die größer als der äußeren Durchmesser der Anschlußdrähte (5) des Kondensators (1) ist, auf einen Wandabschnitt (11) an dem vorderen Ende der Öffnung für die Abdeckung eines Teils derselben angeordnet ist.

2. Kondensatoranordnung der Chip-Art nach Anspruch 1, dadurch gekennzeichnet, daß eine Harzschicht (19) angeordnet ist, um mindestens einen Herausleit-Abschnitt der Anschlußdrähte (5) von der Kondensatorabdichtverbindung für eine Seite der Öffnung des Hüllrahmens (2) abzudecken, von welcher die Anschlußdrähte (5) des Kondensators (1), der in dem Hüllrahmen (2) angeordnet ist, herausgeführt werden.

3. Kondensatoranordnung der Chip-Art nach Anspruch 1, dadurch gekennzeichnet, daß der Wandabschnitt (11) an einem Ende der Öffnung auf einer Seite des Hüllrahmens (2) angeordnet ist, um einen Teil desselben abzudecken, und Anschlußdrähte (5) des Kondensators (1), der in dem Hüllrahmen (2) aufgenommen ist, entlang von einer Öffnung auf einer Seite des Hüllrahmens (2) zu dem Wandabschnitt (11) und der Unterseite (8) gebogen sind.

4. Kondensatoranordnung der Chip-Art nach Anspruch 3, dadurch gekennzeichnet, daß Schlitzabschnitte (14, 15) angeordnet sind, um Anschlußdrähte auf dem Wandabschnitt (11) aufzunehmen, der an einem Ende der Öffnung auf einer Seite des Hüllrahmens (2) angeordnet ist, um einen Teil desselben abzudecken, über welchen die Anschlußdrähte (2) des Kondensators (1) gebogen werden.

5. Kondensatoranordnung der Chip-Art nach Anspruch 3, dadurch gekennzeichnet, daß mindestens ein Anschlußdraht (2) entlang der Unterseite (8) des Hüllrahmens (2) verläuft.

## Revendications

1. Ensemble à condensateur de type pastille, comprenant un condensateur (1) équipé de fils conducteurs (5) partant de ses bornes, et un cadre de blindage (2) possédant inne face inférieure (8) et définissant un espace de logement (6) complémentaire de la forme extérieure dudit condensateur (1), les fils conducteurs (5) du condensateur (1) logé dans le cadre de blindage (2) étant repliés le long du cadre de blindage (2) jusqu'à la face inférieure (8) de ce cadre, caractérisé en ce qu'une protubérance possédant inne hauteur sensiblement égale au diamètre extérieur des fils conducteurs (5) est prévue sur la face inférieure (8) du cadre de blindage (2), qu'une seule ouverture pour la sortie des fils conducteurs (5) est prévue au niveau d'une extrémité avant du cadre de blindage et qu'une protubérance (11,16) possédant inne épaisseur supérieure au diamètre extérieur des fils conducteurs (5) du condensateur (1) est prévue sur un élément de paroi (11) disposé sur l'extrémité avant de l'ouverture pour recouvrir une partie de cette ouverture.

2. Ensemble à condensateur de type pastille selon la revendication 1, dans lequel il est prévu une couche de résine (19) servant à recouvrir au moins une section de sortie des fils conducteurs (5) à partir du composé d'étanchéité du condensateur, pour un côté de l'ouverture du cadre de blindage (2), à partir duquel ressortent les fils conducteurs (5) du condensateur (1), qui est logé dans le cadre de blindage (2).

3. Ensemble à condensateur de type pastille selon la revendication 1, dans lequel l'élément de paroi (11) est disposé: à inne extrémité de l'ouverture d'un côté du cadre de blindage (2) de manière à recouvrir une partie de ce dernier et que des fils conducteurs (5) du condensateur (1) logé dans le cadre de blindage (2) sont repliés, à partir d'une ouverture, le long d'un côté du cadre de blindage (2) jusqu'à l'élément de paroi (11) et jusqu'à la face inférieure (8).

4. Ensemble à condensateur de type pastille selon la revendication 3, dans lequel des sections rainurées (14,15) sont prévues de manière à loger des fils conducteurs situés sur l'élément de paroi (11) disposé à une extrémité de l'ouverture, d'un côté du cadre de blindage (2) pour recouvrir une partie de ce cadre, sur laquelle des fils conducteurs (2) du condensateur sont repliés.

5. Ensemble à condensateur de type pastille selon la revendication 3, dans lequel au moins l'un desdits fils conducteurs (2) s'étend le long de la face inférieure (8) du cadre de blindage (2).
